(19) Europäisches Patentamt
European Patent Office
Office européen des brevets

(11) Numéro de publication: **0 203 849 B1**

(12) # FASCICULE DE BREVET EUROPEEN

(45) Date de publication du fascicule du brevet: **28.11.90**

(51) Int. Cl.⁵: **G11C 19/08**

(21) Numéro de dépôt: **86401036.8**

(22) Date de dépôt: **14.05.86**

(54) **Générateur de bulles magnétiques pour mémoire à bulles en technologie hybride.**

(30) Priorité: **21.05.85 FR 8507620**

(43) Date de publication de la demande: **03.12.86 Bulletin 86/49**

(45) Mention de la délivrance du brevet: **28.11.90 Bulletin 90/48**

(84) Etats contractants désignés: **DE GB NL**

(56) Documents cités:
**US-A- 3 967 002**
**US-A- 4 128 895**

**IEEE TRANSACTIONS ON MAGNETICS, vol. MAG-9, no. 3, septembre 1973, pages 289-293, IEEE, New York, US; T.J. NELSON et al.: "Field nucleation of magnetic bubbles"**
**IEEE INTERNATIONAL SOLID-STATE CIRCUITS CONFERENCE, février 1980, pages 112,113, IEEE, New York, US; S.J. NICOLINO Jr.: "Session IX: LSI systems"**

(73) Titulaire: **COMMISSARIAT A L'ENERGIE ATOMIQUE, 31/33, rue de la Fédération, F-75015 Paris(FR)**

(72) Inventeur: **Fedeli, Jean-Marc, 3, rue Bach Le Fontanil, F-38120 Saint-Egreve(FR)**
Inventeur: **Louis, Christine, 5, rue du Drac, F-38120 Saint-Egreve(FR)**
Inventeur: **Pisella, Christian, "Le Mollard" Beaucroissant, F-38140 Rives/Fure(FR)**

(74) Mandataire: **Mongrédien, André et al, c/o BREVATOME 25, rue de Ponthieu, F-75008 Paris(FR)**

EP 0 203 849 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention a pour objet un générateur de bulles magnétiques pour une mémoire à bulles en technologie hybride, c'est-à-dire comportant des motifs déposés, en permalloy ou en FeNi par exemple, et des motifs non implantés.

Dans une mémoire à bulles magnétiques, les bulles magnétiques sont contenues dans une couche magnétique monocristalline, telle qu'un film de grenat magnétique, supportée par un grenat monocristallin amagnétique. Ces bulles se présentent sous la forme de domaines magnétiques isolés, généralement cylindriques, présentant une aimantation inverse de celle du reste de la couche magnétique monocristalline. Ces bulles magnétiques sont stables par application d'un champ magnétique continu $H_P$ perpendiculaire au plan de la couche magnétique. Dans la pratique, ce champ magnétique est créé par un aimant permanent assurant ainsi la non volatilité des informations contenues dans la mémoire à bulles.

Dans une mémoire à bulles magnétiques, le déplacement des bulles est réalisé en appliquant un champ continu tournant $H_T$ suivant une direction parallèle à la surface de la couche magnétique. Le déplacement des bulles se fait autour de motifs dits de propagation.

Ces motifs présentant la forme de disques, de losanges, de triangles, de T etc... peuvent être réalisés en un matériau à base de fer et de nickel, déposé sur une couche isolante recouvrant la couche magnétique, ou bien obtenus en implantant des ions dans la partie supérieure de la couche magnétique, à travers un masque permettant de définir la forme de ces motifs. Dans ce dernier cas, étant donné que l'implantation ionique n'est effectuée qu'autour des motifs, ces motifs sont appelés des motifs non implantés. Les motifs de propagation sont généralement contigus ; du fait de leur forme, deux motifs adjacents délimitent entre eux deux cavités ou creux.

Le déplacement des bulles le long de ces motifs se fait généralement pendant une durée égale au tiers de la période de rotation du champ magnétique $H_T$ plan, les bulles restant immobiles dans les cavités définies entre deux motifs adjacents, pendant le reste du cycle. Ces cavités constituent des positions dites stables. On réalise ainsi des registres à décalage dans lesquels l'information binaire "1" est représentée par la présence d'une bulle et l'information binaire "0" par l'absence d'une bulle.

En plus de ces motifs de propagation, il est nécessaire d'utiliser des conducteurs électriques pour réaliser dans la mémoire à bulles, des fonctions d'écriture, d'enregistrement de l'information, de lecture non destructive, de transfert de registre à registre et d'effacement.

Un des principaux types de mémoire à bulles magnétiques connus comprend un ensemble de boucles, ou registres, dites mineures servant au stockage des informations, associé à une ou deux boucles, ou registres, dites majeures, constituant les stations d'accès à la mémoire. Les boucles mineures sont disposées longitudinalement, les unes à côté des autres et les boucles majeures sont orientées perpendiculairement aux boucles mineures. Les bulles magnétiques se trouvant dans les boucles mineures peuvent être transférées dans les boucles majeures et réciproquement, par l'intermédiaire de portes de transfert unidirectionnelles ou bidirectionnelles.

Lorsque l'on utilise une seule boucle majeure, la lecture et l'écriture des informations se font au moyen de cette unique boucle. Dans ce premier cas, on parle d'une mémoire présentant une organisation majeure-mineure. En revanche, lorsque l'on utilise deux boucles majeures, l'écriture des informations se fait par l'intermédiaire de l'une de ces deux boucles et la lecture des informations par l'intermédiaire de l'autre boucle. Ces boucles majeures sont généralement situées de part et d'autre des boucles mineures. Dans ce dernier cas (deux boucles), on parle généralement d'une mémoire présentant une organisation série-parallèle.

Une mémoire à bulles se compose de trois modules : un module d'écriture, un module de stockage et un module de lecture.

Le module d'écriture comporte un générateur de bulles, une boucle majeure d'écriture et des portes d'échange pour transférer des bulles magnétiques de la boucle majeure d'écriture vers les boucles mineures. Le module de stockage comporte un ensemble de boucles mineures sur lesquelles sont mémorisées les bulles. Le module de lecture comporte une boucle majeure de lecture, un ensemble de portes de duplication pour recopier des bulles magnétiques des boucles mineures sur la boucle majeure de lecture, et un moyen de détection.

Dans une mémoire à bulles magnétiques en technologie hybride, les modules d'écriture et de lecture sont réalisés en motifs déposés, et le module de stockage est réalisé en motif non implanté, ceci pour permettre une densité de stockage d'information maximale.

Selon l'art connu, les seuls motifs utilisés dans un générateur de bulles magnétiques dans une mémoire à bulles en technologie hybride sont des motifs déposés. On a représenté sur la figure 1 un mode de réalisation d'un tel générateur de bulles connu.

Ce générateur de bulles 2 comprend un conducteur électrique 4 et un motif déposé 6. Le conducteur électrique 4, ayant la forme générale d'un U, est déposé sur une couche électriquement isolante recouvrant la couche magnétique dans laquelle se déplacent les bulles. Le motif déposé 6 est réalisé sur une couche électriquement isolante recouvrant le conducteur électrique 4.

La position de nucléation, ou position de génération d'une bulle, est définie par la partie de l'espace intérieur du conducteur électrique 4 se trouvant au voisinage d'un bord du motif déposé 6. Ce dernier a une forme conçue pour créer un fort pôle magnétique sur ce bord.

Lorsque le conducteur électrique 4 est parcouru par un courant, il se crée dans son espace intérieur un champ magnétique, ce qui engendre localement, dans la couche magnétique, un domaine magnétique. Pour un sens donné du courant électrique parcourant le conducteur électrique 4, le domaine magnétique créé a une aimantation opposée à l'aimantation de la couche magnétique ; ce domaine d'aimantation constitue ainsi une bulle magnétique.

L'impulsion de courant émise dans le conducteur électrique 4 doit être synchronisée avec le champ tournant $H_T$ Sur la figure 1, l'impulsion de courant doit être émise à l'instant de la phase 1 du champ tournant $H_T$. La bulle est alors créée dans la position $a_1$ Elle se déplace ensuite avec le champ tournant $H_T$ dans les positions $a_2$, $a_3$. A l'instant suivant, elle franchit l'intervalle entre le motif déposé 6 et un motif déposé 8 de la boucle majeure d'écriture.

La couche d'isolant électrique séparant le conducteur électrique 4 de la couche magnétique contenant les bulles doit avoir une épaisseur suffisante pour ne pas induire des contraintes mécaniques du conducteur 4 sur la couche magnétique. Or, plus l'épaisseur de cette couche est importante, et plus le courant de nucléation doit être intense.

Le choix de l'épaisseur de cette couche d'isolant électrique résulte donc d'un compromis entre deux paramètres antagonistes. On choisit en général une épaisseur de l'ordre de 100 nm, ce qui fixe l'intensité du courant de nucléation à environ 200 mA. Cette épaisseur est faible et peut poser des problèmes de contraintes mécaniques.

Cependant, l'intensité du courant de nucléation nécessaire est importante pour nucléer les bulles à faible température. Or, on sait que le courant de nucléation nécessaire est d'autant plus faible que la température de la mémoire est élevée. Le courant de nucléation n'étant pas ajusté en fonction de la température, mais étant maintenu constant, ce courant de nucléation est en général trop élevé lorsque la température de la mémoire dépasse 80°C environ. Il est alors courant que la bulle magnétique en cours de nucléation s'étende dans l'espace intérieur selon l'axe du conducteur électrique et se scinde en deux bulles magnétiques, lorsque le champ tournant $H_T$ passe de la phase 1 à la phase 2, ce qui crée des erreurs aléatoires dans la mémoire.

Le générateur de bulles magnétiques représenté sur la figure 1 illustre la structure classique d'un générateur de bulles magnétiques dans une mémoire à motifs déposés ou dans une mémoire en technologie hybride. Dans une mémoire à motifs non implantés, la structure du générateur de bulles est semblable à celle du générateur de bulles de la figure 1, la seule différence résidant dans le remplacement des motifs déposés par des motifs non implantés. La figure 2 illustre un mode de réalisation d'un générateur de bulles magnétiques dans une mémoire à motifs non implantés.

La boucle majeure de lecture est composée d'une suite de motifs non implantés 10 contigus, la jonction entre deux motifs non implantés successifs définissant une position stable pour les bulles magnétiques. Un conducteur électrique 4 en forme de U est disposé perpendiculairement à l'axe de la boucle majeure d'écriture. L'axe de ce conducteur électrique est confondu avec l'axe de jonction entre deux motifs non implantés consécutifs. La position de nucléation est définie par la base de l'espace intérieur du conducteur électrique 4; cette position de nucléation est une position stable du chemin de propagation sur la boucle majeure.

Le générateur de bulles magnétiques de la figure 2 fonctionne de la même manière que le générateur de la figure 1. Le courant de nucléation est émis dans le conducteur électrique 4 en relation avec la phase du champ tournant $H_T$. Dans le mode de réalisation de la figure, ce courant de nucléation est émis pendant la phase 3 du champ tournant.

L'intensité du courant de nucléation est de l'ordre de 150 mA lorsque la couche électriquement isolante disposée entre la couche magnétique et le conducteur électrique a une épaisseur de l'ordre de 100 nm.

D'autre part, l'on pourra se reporter à l'état de la technique constitué par le document IEEE International Solid State Circuits Conference, Février 1980, p. 112–113, qui décrit un générateur de bulles magnétiques, ayant à la surface de la couche magnétique une couche implantée. Un motif implanté n'est pas prévu.

L'on pourra également se reporter à l'état de la technique constitué par le document US-A 4 128 895, dans lequel il est mentionné qu'une réduction du courant de nucléation peut être obtenue en prévoyant une paroi chargée (cf. colonne 8, lignes 61–67), d'où il ressort qu'un domaine de nucléation sans paroi chargée, figure 3A, a besoin de 700 mA et qu'un domaine de nucléation avec paroi chargée, figure 5A, n'a besoin que de 150 mA et qu'une telle paroi chargée peut être constituée par une région implantée dans la couche magnétique, cette région formant un motif implanté.

Cependant, aucun des documents de l'état de la technique ne permet de résoudre le problème d'une réduction importante des courants de nucléation, c'est à dire d'obtenir ces courants de l'ordre de 50 mA.

L'invention a pour but de remédier aux inconvénients des générateurs de bulles magnétiques connus pour les mémoires à bulles en technologie hybride.

En effet, l'invention permet d'éviter les doubles nucléations et également de diminuer encore plus les courants de nucléation.

L'invention consiste donc à ajouter au générateur une zone implantée disposée au moins au droit de la position de nucléation afin de créer au-dessous de cette zone implantée une diminution des forces qui s'opposent au renversement de l'aimantation et ainsi de réduire l'amplitude du courant de nucléation dans une proportion importante, ces courants étant de l'ordre de 50 mA.

L'invention consiste également à choisir une forme de la zone implantée de manière à limiter l'extension de la bulle nuclée dans l'espace intérieur du conducteur électrique.

Selon le premier mode de réalisation, l'invention a pour objet un générateur de bulles magnétiques pour mémoire à bulles en technologie hybride comprenant une couche magnétique dans laquelle une bulle magnétique peut se déplacer sous l'action d'un champ tournant, un motif déposé composé d'un matériau magnétique à forte perméabilité et séparé de la couche magnétique par une couche d'isolant électrique, un conducteur électrique en forme de U disposé entre ladite couche magnétique et ledit motif déposé et isolé électriquement de ceux-ci, le motif déposé recouvrant la base de l'espace intérieur défini par le conducteur électrique, la partie recouverte simultanément par ledit motif déposé et l'espace intérieur dudit conducteur électrique constituant une position de nucléation, ledit générateur étant caractérisé en ce qu'il comprend un motif implanté réalisé dans une fraction de l'épaisseur de la couche magnétique, ledit motif implanté recouvrant au moins la position de nucléation, et en ce que le motif implanté a sensiblement la forme d'un trapèze dont les bases ont une direction sensiblement perpendiculaire à l'axe du conducteur électrique, la petite base étant la plus proche de la position de nucléation.

Selon le second mode de réalisation, l'invention a pour objet un générateur de bulles magnétiques pour mémoire à bulles en technologie hybride comprenant une couche magnétique dans laquelle une bulle magnétique peut se déplacer sous l'action d'un champ tournant, un motif déposé composé d'un matériau magnétique à forte perméabilité et séparé de la couche magnétique par une couche d'isolant électrique, un conducteur électrique en forme de U disposé entre ladite couche magnétique et ledit motif déposé et isolé électriquement de ceux-ci, le motif déposé recouvrant la base de l'espace intérieur défini par le conducteur électrique, la partie recouverte simultanément par ledit motif déposé et l'espace intérieur dudit conducteur électrique constituant une position de nucléation, ledit générateur étant caractérisé en ce qu'il comprend un motif implanté réalisé dans une fraction de l'épaisseur de la couche magnétique, ledit motif implanté recouvrant au moins la position de nucléation, et en ce que le motif implanté et le motif déposé se recouvrent partiellement, dans la direction de progression de la bulle engendrée, jusqu'à une position stable de la bulle sur le motif déposé.

De préference, les frontières du motif implanté sont, dans l'espace intérieur du conducteur électrique, au voisinage de la position de nucléation.

Cette forme particulière permet de limiter l'extension, suivant l'axe du conducteur électrique, de la bulle engendrée. On évite ainsi la nucléation simultanée de plusieurs bulles.

De manière préférée, l'axe du conducteur électrique est parallèle à un axe de facile aimantation de la couche magnétique. Une telle structure présente l'avantage de rendre plus stable la position de nucléation.

La zone implantée peut s'étendre plus ou moins loin dans le sens de propagation de la bulle engendrée. Selon un premier mode de réalisation préféré, la frontière du motif implanté, franchie par la bulle engendrée dans sa progression le long du bord du motif déposé, se trouve au voisinage de la position de nucléation. La nucléation de la bulle et le franchissement de la frontière zone implantée-zone non implantée sont alors réalisés simultanément.

Dans un tel générateur, les étapes de génération de la bulle et de franchissement de la frontière zone implantée-zone non implantée sont séparées dans le temps.

Les caractéristiques et avantages de l'invention ressortiront mieux de la description qui va suivre, donnée à titre illustratif mais non limitatif, en référence aux dessins annexés, sur lesquels:

– le figure 1, déjà décrite, représente un générateur de bulles magnétiques connu pour une mémoire à bulles magnétiques à motifs déposés ou en technologie hybride,

– la figure 2, déjà décrite, représente un générateur de bulles magnétiques connu pour une mémoire à bulles magnétiques à motifs non implantés,

– la figure 3 represente un premier mode de réalisation d'un générateur de bulles magnétiques selon l'invention pour une mémoire en technologie hybride,

– la figure 4 est une vue en coupe selon l'axe AA du générateur de la figure 3,

– la figure 5 représente un second mode de réalisation d'un générateur de bulles magnétiques selon l'invention pour une mémoire en technologie hybride.

On a représenté sur la figure 3 un premier mode de réalisation d'un générateur de bulles magnétiques conforme à l'invention. Ce générateur 12 comprend, de manière connue, un conducteur électrique 14 en forme de U et un motif déposé 16. Ces deux éléments définissent de manière connue une position de nucléation P située sur le bord du motif déposé 16 dans l'espace intérieur du conducteur électrique 14.

Le générateur de bulles magnétiques 12 comprend en outre, selon l'invention, une zone implantée 18. Celle-ci recouvre au moins la position de nucléation P.

La vue en coupe suivant AA représentée sur la figure 4 illustre les différentes couches technologiques constituant le générateur de bulles magnétiques de l'invention. Ce générateur comprend, sur un substrat amagnétique 24, une couche magnétique 26 obtenue par épitaxie. Cette couche constitue le domaine des bulles magnétiques tel que 28. Dans la partie supérieure de cette couche magnétique 26, par exemple dans le tiers supérieur, sont réalisés des motifs implantés tels que le motif implanté 18 par implantation ionique. Cette couche magnétique est recouverte d'une couche électriquement isolante 30 par exemple en $SiO_2$. Sur cette couche est déposée une couche électriquement conductrice, par exemple en Au, dans laquelle est gravé le conducteur électrique 14. Une couche isolante électriquement 32, par exemple en $SiO_2$, est ensuite déposée. Sur celle-ci, on réalise le motif déposé 16 composé par exemple de permalloy ou de FeNi. Une dernière couche de passivation 34, par exemple en $SiO_2$, termine la réalisation du générateur.

Il faut noter que, dans cette coupe schématique, les épaisseurs relatives des couches n'ont pas été respectées. La couche amagnétique 24 a une épaisseur de l'ordre de 500 μm, la couche magnétique 26 une épaisseur de l'ordre de 1 μm et la couche électriquement isolante 30 une épaisseur de l'ordre de 100 nm.

Revenons maintenant à la figure 3. La zone implantée 18 du générateur 12 crée dans la zone de la position de nucléation P, une diminution des forces magnétiques qui s'opposent au renversement de l'aimantation dans la couche magnétique 26, c'est-à-dire à la création d'une bulle magnétique. L'expérience montre que l'on peut ainsi réduire l'amplitude du courant de nucléation d'un facteur de l'ordre de 2 à 3 par rapport au courant de nucléation utilisé dans l'art antérieur. Ceci permet, par rapport l'art antérieur, d'augmenter l'épaisseur de la couche d'isolant électrique 30.

La nucléation d'une bulle magnétique dans la position de nucléation P est d'autant plus facile que le motif déposé 16 crée un pôle magnétique intense au voisinage de la position de nucléation. Ceci est réalisé, de manière classique, en utilisant un motif déposé 16 ayant une longueur importante suivant l'axe du conducteur électrique 14. La nucléation peut aussi être facilitée, de manière connue, en disposant le conducteur électrique tel que son axe soit parallèle à un axe de facile aimantation de la couche magnétique 26. Enfin, la zone implantée 18 favorise également la nucléation d'une bulle magnétique.

A titre d'exemple, on a représenté sur la figure 3 une zone implantée 18 de forme trapézoïdale. Bien entendu, cette forme n'est pas la seule possible. Toutefois, de manière préférée, la zone implantée 18 a une forme telle que son extension x dans l'espace intérieur défini par le conducteur électrique 14, et selon l'axe de ce conducteur, reste limitée à une longueur de quelques diamètres de bulle magnétique. En effet, une bulle magnétique restant, au moment de sa nucléation, dans l'espace défini par l'intersection entre la zone implantée 18 et l'espace intérieur du conducteur électrique 14, cette forme particulière de la zone implantée 18 permet de limiter l'extension de la bulle nucléée dans l'espace intérieur du conducteur 14 et supprime ainsi la possibilité de double nucléation.

La frontière 20 de la zone implantée 18, qui se trouve avant la position de nucléation P par rapport au sens de propagation des bulles magnétiques sur le bord du motif déposé 16 se trouve également de préférence au voisinage de l'espace intérieur du conducteur 14.

On a indiqué par des références $a_1$, $a_2$, $a_3$, $a_4$, $b_1$,... les positions successives d'une bulle magnétique se déplaçant sous l'action du champ tournant $H_T$. Dans ces références, l'indice numérique note la phase du champ tournant $H_T$. Une bulle magnétique est créée dans la position de nucléation P par application d'un courant de nucléation dans le conducteur électrique 14 pendant la phase 1 du champ tournant $H_T$. Ce courant de nucléation a une intensité de l'ordre de 50 mA.

Dans le générateur de la figure 3, la bulle engendrée franchit immédiatement la frontière zone implantée-zone non implantée. Elle se déplace sur le bord du motif déposé 16 et franchit, entre les phases 3 et 4 du champ tournant $H_T$, l'espace entre le motif déposé 16 et le premier motif déposé 22 de la boucle majeure d'écriture.

On a représenté sur la figure 5 un second mode de réalisation du générateur de bulles magnétiques selon l'invention. Dans ce générateur, les étapes de création de la bulle magnétique et de transfert de cette bulle hors de la zone implantée sont dissociées. La fiabilité du générateur s'en trouve améliorée.

Le générateur représenté sur la figure 5 comporte un conducteur électrique 36 en forme de U, un motif déposé 38 et une zone implantée 40. Une extrémité du motif déposé 38 est disposée, de manière classique, au voisinage de la base de l'espace intérieur du conducteur électrique 36, définissant ainsi la position de nucléation P. La zone implantée 40 est disposée, conformément à l'invention, de manière à recouvrir au moins la position de nucléation P.

Pour dissocier les étapes de création et de transfert de la bulle engendrée hors de la zone implantée, cette zone implantée est prolongée sur une distance importante sur le chemin de propagation de la bulle à partir de la position de nucléation P. Cette zone implantée 40 se prolonge, par exemple, au moins jusqu'à la première position stable du chemin de propagation sur le motif déposé 38.

Comme dans le mode de réalisation du générateur représenté sur la figure 3, la nucléation d'une bulle magnétique est favorisée par la forme du motif déposé 38 et par la forme de la zone implantée 40. En particulier, l'intensité du pôle magnétique créé par le motif déposé 38 est augmentée par la forme allongée de la branche 42 de ce motif déposé dont l'extrémité coïncide avec la position de nucléation P. De même, l'axe du conducteur électrique est de préférence parallèle à un axe de facile aimantation de la couche magnétique.

L'extension de la zone implantée dans l'espace intérieur défini par le conducteur électrique 36 est limitée ; la frontière 44 de la zone implantée dans cet espace intérieur reste au voisinage de la position de nucléation P, par exemple à une distance de l'ordre de quelques diamètres de bulle magnétique. Ceci permet d'éviter des doubles nucléations. Enfin, la frontière 46 de la zone implantée qui se trouve avant la position de nucléation P, par rapport au sens de propagation d'une bulle magnétique le long du motif déposé 38, est également de préférence à proximité de la position de nucléation P.

Les références $a_4$, $b_1$, $b_2$, $b_3$, $b_4$, $c_1$,... indiquent les positions successives d'une bulle magnétique en fonction de la phase du champ tournant $H_T$ ; l'indice numérique note la phase de ce champ. Dans le générateur de la figure 5, une bulle magnétique est créée lorsque le champ tournant $H_T$ se trouve en phase 4, par application d'un courant de nucléation dans le conducteur électrique 36. L'intensité du courant de nucléation est de l'ordre de 50 mA. Entre les phases 4 et 1 du champ tournant $H_T$, la bulle magnétique créée se déplace en suivant le bord du motif déposé 38 jusqu'à la position stable $b_1$ où elle franchit la frontière de la zone implantée.La bulle magnétique continue ensuite à se déplacer en suivant le bord du motif déposé 38 et est transférée, entre les phases 3 et 4 du champ tournant $H_T$, du motif déposé 38 au premier motif déposé 22 de la boucle majeure d'écriture.

## Revendications

1. Générateur de bulles magnétiques pour mémoire à bulles en technologie hybride comprenant une couche magnétique (26) dans laquelle une bulle magnétique (28) peut se déplacer sous l'action d'un champ tournant, un motif déposé (16) composé d'un matériau magnétique à forte perméabilité et séparé de la couche magnétique par une couche d'isolant électrique (30, 32), un conducteur électrique (14) en forme de U disposé entre ladite couche magnétique (26) et ledit motif déposé (16) et isolé électriquement de ceux-ci, le motif déposé (16) recouvrant la base de l'espace intérieur défini par le conducteur électrique (14), la partie recouverte simultanément par ledit motif déposé (16) et l'espace intérieur dudit conducteur électrique constituant une position de nucléation (P), ledit générateur étant caractérisé en ce qu'il comprend un motif implanté (18) réalisé dans une fraction de l'épaisseur de la couche magnétique (26), ledit motif implanté recouvrant au moins la position de nucléation (P), et en ce que le motif implanté (18) a sensiblement la forme d'un trapèze dont les bases ont une direction sensiblement perpendiculaire à l'axe du conducteur électrique (14), la petite base étant la plus proche de la position de nucléation (P).

2. Générateur de bulles magnétiques pour mémoire à bulles en technologie hybride comprenant une couche magnétique (26) dans laquelle une bulle magnétique (28) peut se déplacer sous l'action d'un champ tournant, un motif déposé (38) composé d'un matériau magnétique à forte perméabilité et séparé de la couche magnétique par une couche d'isolant électrique (30, 32), un conducteur électrique (36) en forme de U disposé entre ladite couche magnétique (26) et ledit motif déposé et isolé électriquement de ceux-ci, le motif déposé (38) recouvrant la base de l'espace intérieur défini par le conducteur électrique (36), la partie recouverte simultanément par ledit motif déposé (38) et l'espace intérieur dudit conducteur électrique constituant une position de nucléation (P), ledit générateur étant caractérisé en ce qu'il comprend un motif implanté (40) réalisé dans une fraction de l'épaisseur de la couche magnétique (26), ledit motif implanté recouvrant au moins la position de nucléation (P), et en ce que le motif implanté (40) et le motif déposé (38) se recouvrent partiellement, dans la direction de progression de la bulle engendrée, jusqu'à une position stable (61) de la bulle sur le motif déposé.

3. Générateur de bulles magnétiques selon la revendication 1, caractérisé en ce que les frontières (44) du motif implanté, dans l'espace intérieur du conducteur électrique (14, 36) sont au voisinage de la position de nucléation.

4. Générateur de bulles magnétiques selon l'une quelconque des revendications 1 et 2, caractérisé en ce que l'axe du conducteur électrique (14, 36) est parallèle à un axe de facile aimantation de la couche magnétique.

5. Générateur de bulles magnétiques selon l'une quelconque des revendications 1 à 3, caractérisé en ce que la frontière du motif implanté (18, 40), franchie par la bulle engendrée dans sa progression le long du bord du motif déposé, se trouve au voisinage de la position de nucléation (P):

## Claims

1. Magnetic bubble generator for a hybrid technology bubble memory having a magnetic layer (26) in which a magnetic bubble can move under the action of a rotary field, a deposited pattern (16) formed from a high permeability magnetic material and separated from the magnetic layer by an electrical insulation layer (30, 32), a U-shaped electric conductor (14) located between said magnetic layer (26) and said deposited pattern (16) and electrically insulated therefrom, the deposited pattern (16) covering the base of the internal space defined by the electric conductor (14), the part simultaneously covered by said deposited pattern (16) and the internal space of said electric conductor constituting a nucleation position (P), said generator being characterized in that it comprises an implanted pattern (18) formed in a fraction of the thickness of the magnetic layer (26), said implanted pattern covering at least the nucleation position (P) and in that the implanted pattern (18) is essentially shaped like a trapezium, whose bases have a direction substantially perpendicular to the axis of the electric conductor (14), the smallest base being closest to the nucleation position (P).

2. Magnetic bubble (28) generator for a bubble memory in hybrid technology comprising a magnetic layer (26) in which a magnetic bubble can move under the action of a rotary field, a deposited pattern (38) constituted by a high permeability magnetic material and separated from the magnetic layer by an electric insulation layer (30, 32), a U-shaped electric conductor (36) placed between said magnetic layer (26) and the deposited pattern and electrically insulated therefrom, the deposited pattern (38) covering the base of the internal space defined by the electric conductor (36), the portion simultaneously covered by said deposited pattern (38) and the internal space of the electric conductor constituting a nucleation position, wherein the generator comprises an implanted pattern (40), produced in a fraction of the thickness of the magnetic layer (26), said implanted pattern at least covering the nucleation position (P) and in that the implanted pattern (40) and the deposited pattern (38) partly overlap in the advance direction of the bubble produced, up to a stable position (61) of the bubble on the deposited pattern.

3. Magnetic bubble generator according to claim 1, characterized in that the boundaries (45) of the implanted pattern in the space within the electric conductor (14, 36) are in the vicinity of the nucleation position.

4. Magnetic bubble generator according to either of the claims 1 and 2, characterized in that the axis of the electric conductor (14, 36) is parallel to an axis of easy magnetization of the magnetic layer.

5. Magnetic bubble generator according to any one of the claims 1 to 3, characterized in that the boundary of the implanted pattern (18, 48), cleared by the bubble produced in its advance along the edge of the deposited pattern, is in the vicinity of the nucleation position (P).

## Patentansprüche

1. Magnetblasengenerator für einen Blasenspeicher in hybrider Technologie mit einer magnetischen Schicht (26), in der sich eine Magnetblase (28) unter der Wirkung eines Drehfeldes bewegen kann; einer abgeschiedenen Grundeinheit, die aus einem magnetischen Material hoher Permeabilität zusammengesetzt ist und von der magnetischen Schicht durch eine elektrisch isolierende Schicht (30, 32) getrennt ist; einem elektrischen Leiter (14) in U-Form, der zwischen der magnetischen Schicht (26) und der abgeschiedenen Grundeinheit (16) angeordnet und von dieser elektrisch isoliert ist, wobei die abgeschiedene Grundeinheit (16) die Basis des durch den elektrischen Leiter (14) gebildeten, inneren Raumes bedeckt, wobei der gleichzeitig von der abgeschiedenen Grundeinheit (16) und dem inneren Raum des elektrischen Leiters bedeckte Teil eine Nukleationsstelle (P) darstellt, wobei der Generator dadurch gekennzeichnet ist, daß er eine implantierte Grundeinheit (18) aufweist, die in einem Bruchteil der Dicke der magnetischen Schicht (26) ausgeführt ist, wobei die implantierte Grundeinheit wenigstens die Nukleationsstelle (P) bedeckt, und daß die implantierte Grundeinheit (18) ziemlich genau die Form eines Trapezes besitzt, dessen Basisseiten eine Richtung ziemlich genau senkrecht zur Achse des elektrischen Leiters (14) besitzen, wobei die kleinere Basisseite näher an der Nukleationsstelle (P) liegt.

2. Magnetblasengenerator für einen Blasenspeicher in hybrider Technologie mit einer magnetischen Schicht (26), in der sich eine Magnetblase (28) unter der Wirkung eines Drehfeldes bewegen kann; einer abgeschiedenen Grundeinheit, die aus einem magnetischen Material hoher Permeabilität zusammengesetzt ist und von der magnetischen Schicht durch eine elektrisch isolierende Schicht (30, 32) getrennt ist; einem elektrischen Leiter (36) in U-Form, der zwischen der magnetischen Schicht (26) und der abgeschiedenen Grundeinheit (38) angeordnet und von dieser elektrisch isoliert ist, wobei die abgeschiedene Grundeinheit (38) die Basis des durch den elektrischen Leiter (36) gebildeten, inneren Raumes bedeckt, wobei der gleichzeitig von der abgeschiedenen Grundeinheit (38) und dem inneren Raum des elektrischen Leiters bedeckte Teil eine Nukleationsstelle (P) darstellt, wobei der Generator dadurch gekennzeichnet ist, daß er eine implantierte Grundeinheit (40) aufweist, die in einem Bruchteil der Dicke der magnetischen Schicht (26) ausgeführt ist, wobei die implantierte Grundeinheit wenigstens die Nukleationsstelle (P) bedeckt, und daß die implantierte Grundeinheit (40) und die abgeschiedene Grundeinheit (38) sich teilweise in der Fortbewegungsrichtung der erzeugten Magnetblase bis zu einer stabilen Position (61) der Blase auf der abgeschiedenen Grundeinheit überlappen.

3. Magnetblasengenertor nach Anspruch 1, dadurch gekennzeichnet, daß sich die Grenzen (44) der implantierten Grundeinheit im inneren Raum des elektrischen Leiters (14, 36) in der Nähe der Nukleationsstelle befinden.

4. Magnetblasengenerator nach einem der Ansprüche 1 und 2, dadurch gekennzeichnet, daß die Achse des elektrischen Leiters (14, 36) parallel zu einer Achse leichter Magnetisierung der magnetischen Schicht ist.

5. Magnetblasengenerator nach einem der Ansprüche 1 bis 3, dadurch gekennzeichnet, daß die Grenze der implantierten Grundeinheit (18, 40), die von der erzeugten Magnetblase während ihrer Bewegung entlang der abgeschiedenen Grundeinheit überquert wird, sich in der Nähe der Nukleationsstelle befindet.

FIG. 1

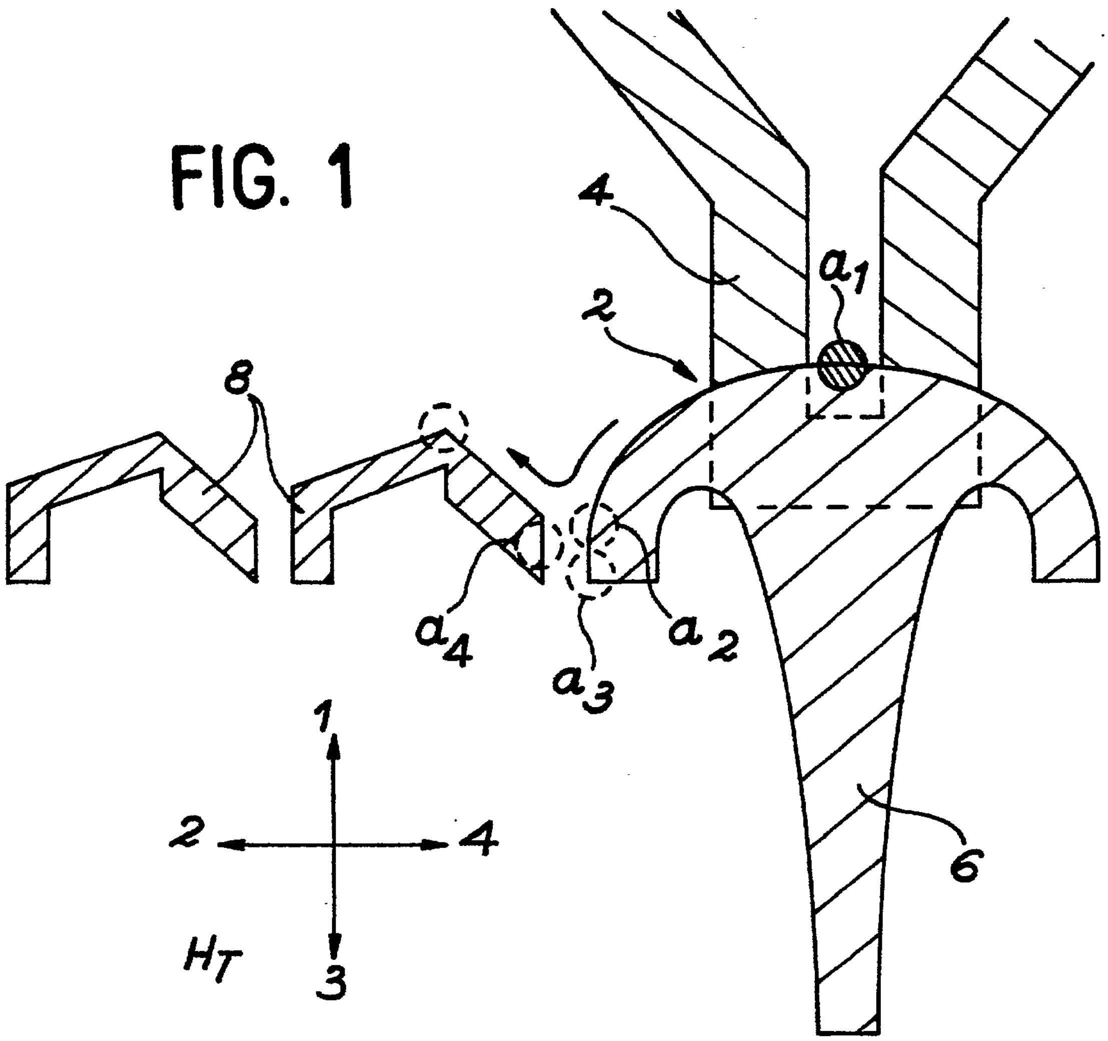


FIG. 2

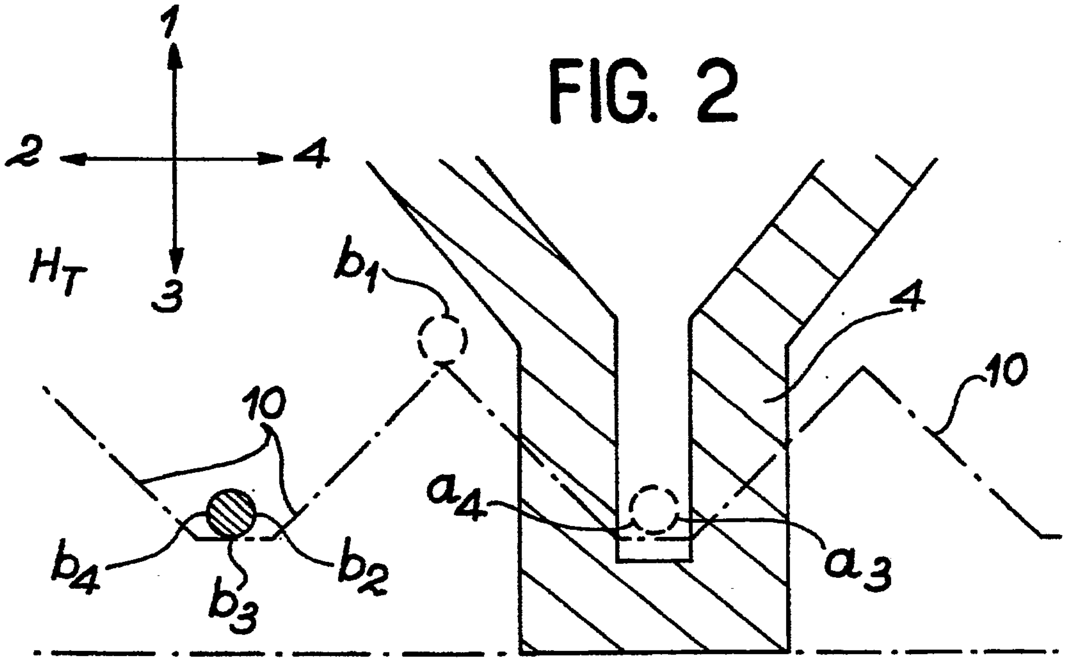

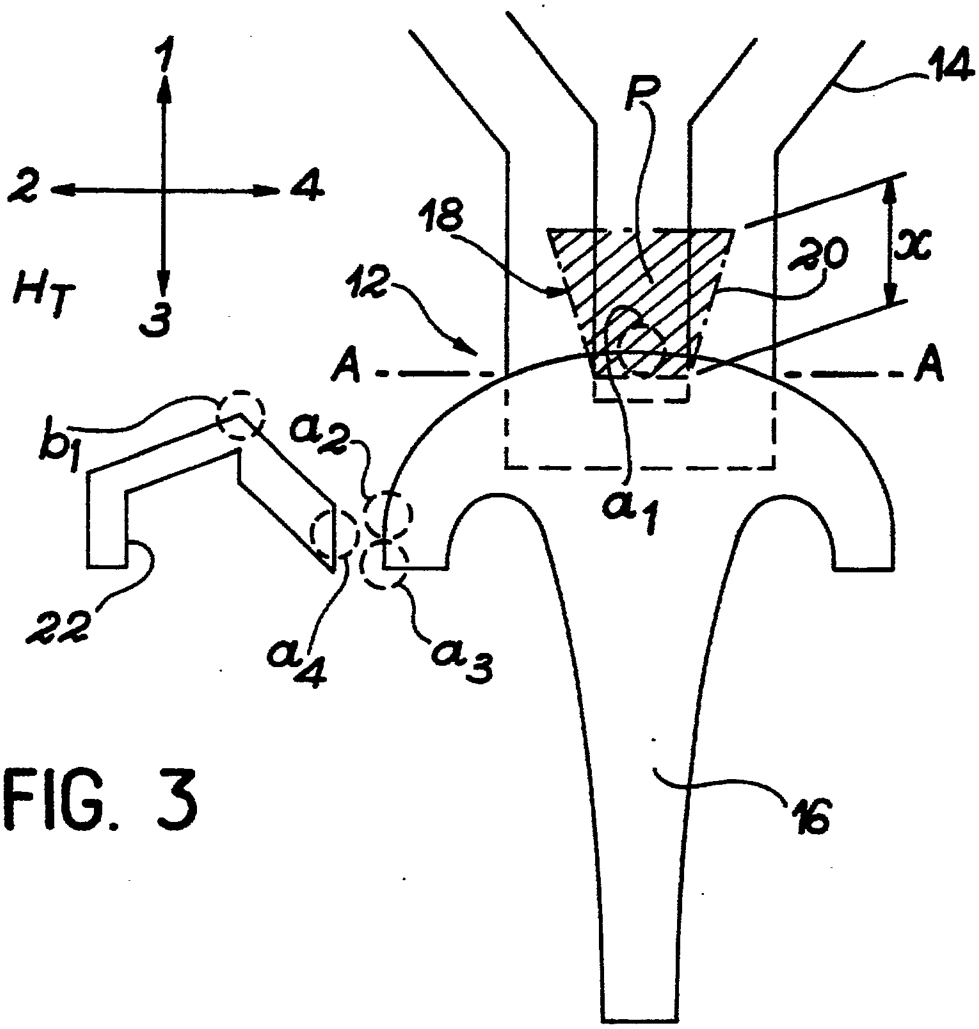
1
2
4
3
$H_T$
14
P
18
x
20
12
A
A
$b_1$
$a_2$
$a_1$
22
$a_4$
$a_3$
16

FIG. 3

FIG. 4

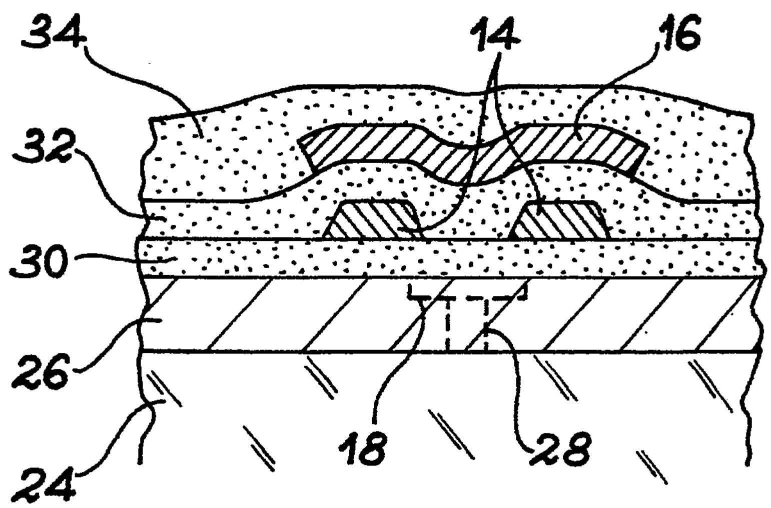
34
14
16
32
30
26
18
28
24

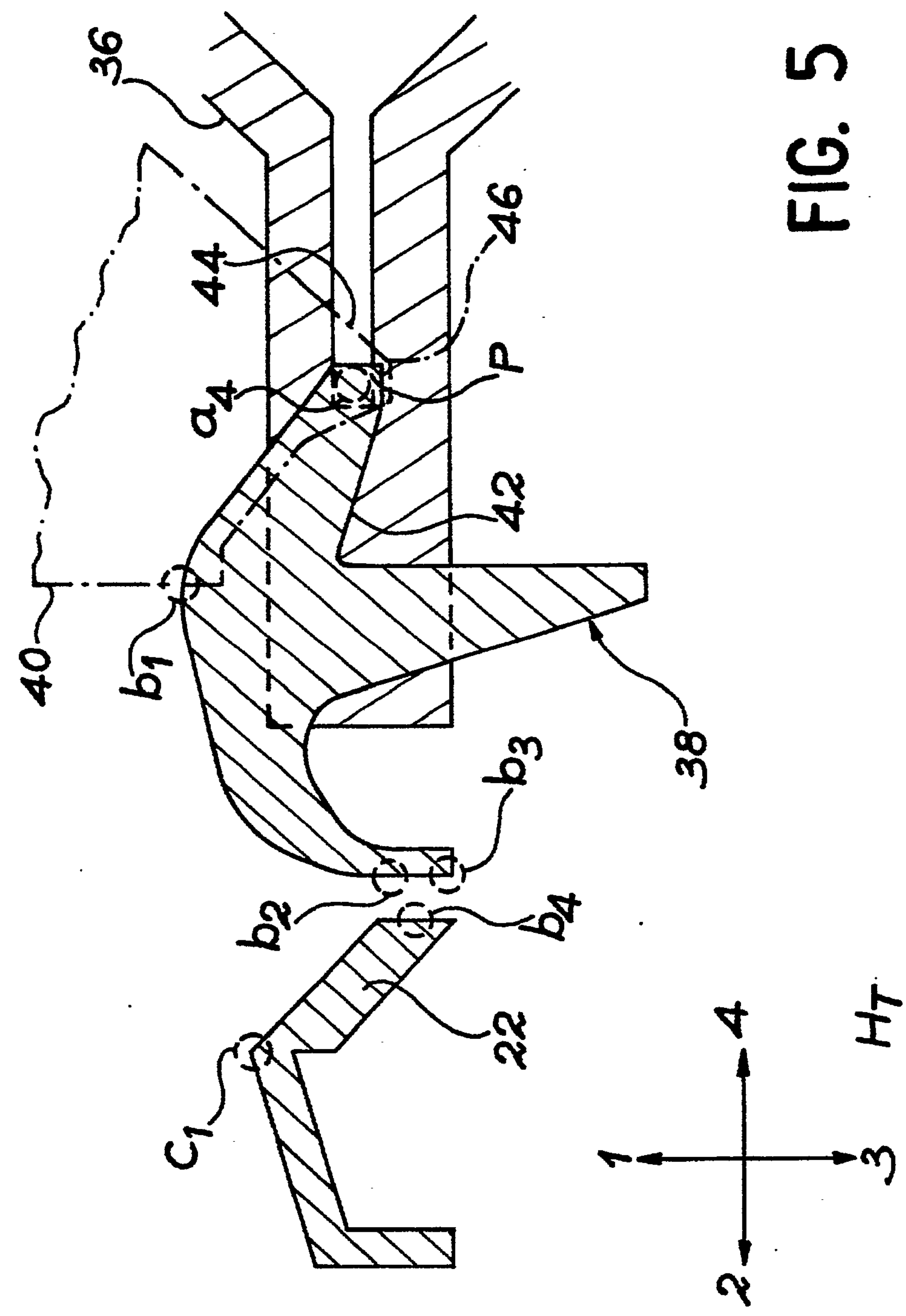


FIG. 5